# EUROPÄISCHE PATENTSCHRIFT

(11) **EP 0 826 745 B1**
(45) Veröffentlichungstag und Bekanntmachung des Hinweises auf die Patenterteilung: **19.02.2003**
(21) Anmeldenummer: 97104852.5
(22) Anmeldetag: 21.03.1997
(51) Int. Cl.: C09C 1/64, C09D 7/12, C09D 11/00, C08K 9/02, C08K 9/08, C09C 1/00

(54) **Korrosionsstabile, durch Physical Vapor Deposition hergestellte Aluminiumpigmente und Verfahren zu deren Stabilisierung**
Corrosion resistant aluminium pigments prepared by physical vapour deposition and process for their stabilization
Pigments d'aluminium résistants à la corrosion préparés par dépôt physique de phase vapeur et procédé pour les stabiliser

(30) Priorität: 30.08.1996 DE 19635085
(43) Veröffentlichungstag der Anmeldung: 04.03.1998
(73) Patentinhaber: ECKART-WERKE STANDARD BRONZEPULVER-WERKE CARL ECKART GMBH & CO., D-90763 Fürth (DE)
(72) Erfinder: Sommer, Günter, Dr., 91207 Lauf (DE); Ostertag, Werner, Dr., 67269 Grünstadt (DE); Kaupp, Günter, Dr., 91284 Neuhaus (DE)
(74) Vertreter: LOUIS, PÖHLAU, LOHRENTZ & SEGETH

(56) Entgegenhaltungen:
- EP-A- 0 595 131
- EP-A- 0 741 170
- US-A- 3 438 796
- US-A- 4 321 087
- DATABASE WPI Week 8925 Derwent Publications Ltd., London, GB; AN 89-181984 XP002082276 & JP 01 119601 A (FUJI PHOTO FILM CO.) , 11. Mai 1989
- DATABASE WPI Week 7445 Derwent Publications Ltd., London, GB; AN 74-78127v XP002082277 & JP 49 031403 A (OIKE & CO.) , 20. März 1974
- DATABASE WPI Week 8610 Derwent Publications Ltd., London, GB; AN 86-065461 XP002082278 & JP 61 016968 A (OIKE KOGYO) , 24. Januar 1986

## Beschreibung

Pigmente, die über Physical Vapor Deposition (PVD) von einoder mehrschichtigen Filmen auf einen Träger, darauf folgendes Ablösen und anschließende Zerkleinerung dieser Filme bzw. Filmpakete hergestellt werden, finden in jüngster Zeit wegen ihrer besonderen optischen Eigenschaften zunehmend Interesse. So wird beispielsweise einschichtiges, über PVD hergestelltes Aluminiumpigment, das unter dem Namen METALURE (eingetragene Marke) bekannt ist, wegen seines überragenden Spiegelglanzes in der Druck- und Lackindustrie geschätzt, während mehrschichtige, sogenannte optisch variable Pigmente, die brillante Interferenzfarben haben und ausgeprägte winkelabhängige Farbtonänderungen bewirken, in Lacken, Kunststoffen und im Wertschriftendruck zunehmend angewendet werden.

Die einschichtigen Aluminiumplättchen von höchstem Glanz des vorstehend erwähnten Aluminiumpigments werden durch Bedampfen eines mit einer Release-Schicht ausgerüsteten Substrats im Vakuum, anschließende Ablösung des Aluminiumfilms und dessen mechanische Zerkleinerung hergestellt ***(US-A 43 21 087)***. Die Dicke der Filmpartikel liegt im allgemeinen unter 100 nm. Die Plättchenoberfläche ist spiegelglatt und von höchster Perfektion. Die Plättchenoberfläche kann aber auch eine hologrammähnliche Prägung aufweisen (WO 93/23481). Solche Plättchen erscheinen dann je nach Prägung in variablen Farben.

*Auch sind bereits durch PVD erzeugte Aluminiumpigmente, die auf einer oder beiden Seiten eine Kunstharzschicht tragen, bekannt (US-A 39 49 139). Die Kunstharzschicht kann als Schutzschicht wirksam sein, jedoch bleiben die bei der Zerkleinerung frei werdenden Bruchflächen ungeschützt.*

Der grundsätzliche Aufbau von optisch variablen Mehrschicht-Pigmenten ist folgender: Auf eine zentrale hochreflektierende Metallschicht M folgen nach jeder Seite hin eine transparente niedrigbrechende Schicht T und dann eine semitransparente Metallschicht M'. Filme, die einen Mehrschichtaufbau vom Typ M'TM aufweisen, sind seit vielen Jahren bekannt (Optical Acta 20, 925-937 (1973), US-A 38 58 977). Pigmente, die das bei Filmen gültige optische Prinzip verkörpern und die oben genannte Schichtenfolge M'TMTM' aufweisen, sind erstmals in der US-A 34 38 796 beschrieben worden. Die plättchenförmigen Pigmentpartikel, für das Anwendungsgebiet dekorativer Lacke gedacht, zeigen brillante Farben und bestehen aus einer mindestens 60 nm dicken hochreflektierenden zentralen Aluminiumschicht, die nach außen hin von je einer 100 bis 600 nm dicken SiO₂- Schicht begleitet wird, auf die dann eine semitransparente 5-40 nm dicke Aluminiumschicht folgt. Darüber ***kann sich*** noch eine ***im PVD-Verfahren aufgebrachte*** SiO₂-Schutzschicht ***befinden.*** Die Herstellung dieser Pigmente erfolgt durch Aufdampfen aufeinanderfolgender Schichten und anschließende Zerkleinerung des mehrschichtigen Films auf die Partikelgröße von Effektpigmenten. Damit die Ablösung des Films vom Substrat erleichtert wird, wird dieses mit einer Releaseschicht belegt. ***Eine Passivierung der entstehenden Partikel ist nicht vorgeschlagen.*** Die Farbe der auf diese Weise produzierten Pigmente hängt von der Dicke der SiO₂-Schichten ab. Jeder Farbton des Spektrums kann über die Wahl der Schichtdicke der SiO₂- Schichten gezielt eingestellt werden. Auch Interferenzfarben höherer Ordnung sind möglich.

Pigmente mit ähnlichem Aufbau und ähnlichem Herstellverfahren sind in US-A 51 35 812 bzw. EP-A 227 423 beschrieben. Diese Pigmente haben einen Mehrschichtenaufbau, wobei die zentrale opake Schicht aus einer hoch reflektierenden Metallschicht, im allgemeinen Aluminium, die nach außen hin folgenden transparenten Schichten aus MgF₂ oder SiO₂ (Brechungsindex n < 1,65) und einer semitransparenten bzw. semiopaken Metallschicht bestehen. Anwendungsgebiet sind Druckfarben für fälschungssichere Banknoten. Die Pigmente werden durch Physical Vapor Deposition im Vakuum und anschließende Zerkleinerung des mehrschichtigen Films im allgemeinen in einem Ultraschallzerkleinerer, auf Pigmentpartikelgröße hergestellt.

Sämtliche in den o.g. Patenten beschriebenen Pigmente haben den Nachteil, daß sie aufgrund freier Metallflächen korrosionsanfällig sind. Zwar lassen sich die aus mehrschichtig aufgedampften Filmen hergestellten Pigmente auf den Großflächen der Pigmentteilchen durch Erzeugung einer Schutzschicht schon im Aufdampfverfahren passivieren, wie dies gemäß US-A 3 438 796 erfolgte. Bei der Zerkleinerung auch des mehrschichtigen Films entstehen jedoch frische Bruchstellen, die verfahrensbedingt ungeschützt und daher sehr korrosionsempfindlich sind. Die chemische Reaktivität der frischen Bruchstellen führt - insbesondere in Gegenwart von Feuchtigkeit, Säuren oder Basen - zu Korrosion und damit zwangsläufig zu einer Verschlechterung der Brillanz und Koloristik der Pigmentplättchen. Dies stellt ein ernsthaftes anwendungstechnisches Problem dar. In US-A 5 498 781 ist ein erster Versuch zur Passivierung optisch variabler Pigmente für wässrige Beschichtungssysteme beschrieben. Das verkaufsfertige optisch variable PigmentPulver wird danach mit einer Silanverbindung vom Typ R₃Si-A-X im speziellen mit (CH₃CH₂O)₃Si (CH₂)₃NH₂ in wässriger alkoholischer Lösung oberflächenbeschichtet, bei 110° C getempert und anschließend in alkoholischer Lösung mit einem Polymer, das funktionelle Isocyanatgruppen trägt, zur Reaktion gebracht. Das Ergebnis ist ein fertiger Lack, wie er zur dekorativen Oberflächenbeschichtung von Automobilen angewendet wird.
Die in US-A 5 498 781 beschriebene Passivierung führt somit zu einem einzigen Anwendungssystem und entbehrt der vielfältigen Anwendungsmöglichkeiten eines passivierten Pigmentes. Ein weiterer Nachteil dieses Passivierungsverfahrens liegt darin, daß die Korrosionsprozesse an den gefährdeten Bruchkanten der optisch variablen Pigmente bereits eingesetzt haben, wenn die Behandlung des fertigen Pigmentpulvers beginnt.

Nun sind bereits zahlreiche Verfahren zur Passivierung von Aluminiumpigmenten bekannt, die durch Mahlverfahren, insbesondere Nassmahlverfahren erzeugt werden (EP-A 595 131, US-A 45 65 716, US-A 48 08 231, US-A 53 56 469, US-A 52 15 579). Diese Aluminiumpigmente weisen jedoch nach dem Abschluß des Herstellungsprozesses durch die dabei auftretenden fortwährenden Walz- und Quetschvorgänge auf den dabei frei werdenden Metallflächen und aufgrund der notwendigen Mühlenbelüftung eine relativ dicke Oxidschicht auf, die eine merkliche Passivierung ergibt. Bei der Herstellung im Nassmahlverfahren, bei dem Schmiermittel wie Stearin- oder Ölsäure eingesetzt werden, ist die Oxidschicht außerdem mit eingewalzten Schmiermittelteilchen versetzt, und bei der Befolgung von Vorschlägen im einschlägigen Stand der Technik (US-A 46 29 512) tritt eine passivierende Oxidhydratschicht hinzu. Die bekannten Passivierungsverfahren und die dazu eingesetzten Agenzien werden somit an schon durch den Herstellungsprozeß deutlich passivierten Aluminiumpigmenten eingesetzt.

Aufgabe der vorliegenden Erfindung war es daher, das Korrosionsverhalten der durch PVD und anschließende Zerkleinerung der Filme hergestellten Pigmente zu verbessern und solche Pigmente bereitzustellen, die auch in aggressiven wäßrigen (insbesondere saurem oder alkalischen) oder lösemittelbasierenden Medien weitgehend stabil bleiben. Hierbei sollten in weiterer Sicht die durch die Filmzerkleinerung entstandenen frischen Bruchstellen, bei optisch variablen Mehrschichtpigmenten, insbesondere die Bruchstellen der zentralen hochreflektierenden Aluminiumschicht passiviert werden.

Diese Aufgabe wird durch Vorschlag von Pigmenten gemäß Anspruch 1 sowie durch eine Behandlung gemäß mindestens einem der selbständigen Verfahrensansprüche gelöst.

Erfindungsgemäß überziehen sich alle freien Metalloberflächen mit einer festhaftenden passivierenden Schicht mit Barrierefunktion. Hierbei wird nach dem erfindungsgemäßen verfahren, die passivierende Schicht während des Schrittes Filmzerkleinerung oder im Anschluß daran aufgebracht, wodurch sie sich also sozusagen in situ unmittelbar bei der Entstehung der frischen Bruchkanten oder sofort danach bildet. Die chemisch aufgebrachte passivierende Schutzschicht muß von einer Art sein, daß sie sich - sofern die Großflachen der Pigmentteilchen ungeschützt sind - an den Großflächen der Pigmentteilchen anlagert, auch und insbesondere jedoch die Bruchflächen überdeckt. Hierzu läßt sich eine Anzahl von Verbindungen und Vorgehensweisen einsetzen:

So kann die passivierende Schutzschicht aus Stoffen der Gruppe langkettige Carbonsäuren, Phosphonsäuren, Phosphorsäure, Alkohole, Amine, Amide und Derivate dieser Stoffe mit 8 bis 20 C-Atomen sowie aus salzartigen Verbindungen dieser Stoffe bestehen. Diese Stoffe werden auf die Pigmentteilchen entweder aus geeigneten Lösungen oder durch Direktbehandlung aufgebracht.

Die Schutzschicht kann aber auch aus mindestens einer Metalloxid-Schicht und/oder einer Metalloxidhydratschicht der Gruppe B, Al, Sn, Ti, V, Cr, Mo, Zn, Ce bestehen. Diese Schicht wird durch eine kontrollierte Hydrolyse entsprechender Salze oder Metallsäureester aufgefällt.

Weiterhin kann die Schutzschicht aus organisch modifizierten Silikaten, Titanaten, Zirkonaten oder Aluminiumzirkonaten bestehen und auch aus entsprechenden organischen Lösungen oder durch Hydrolyse entsprechend modifizierter Metallsäureester aufgebracht werden.

Als Schutzschicht ist auch eine organische Polymerschicht auf Basis von Acrylaten und/oder Methacrylaten möglich, die durch radikalische Polymerisation in Lösung aufgebracht werden. Diese Schutzschicht kann auf die Pigmente oder in einer besonderen Ausgestaltung der Erfindung bereits während der Filmzerkleinerung aufgebracht werden.

Eine Schutzschicht, die durch Kombinationen der vorstehend aufgeführten Stoffe besteht, ist denkbar.

Die Versuche haben überdies ergeben, daß es vorteilhaft ist, anstelle des reinen Aluminiums Aluminiumlegierungen mit größerer Korrosionsbeständigkeit zu verwenden. Besonders hervorzuheben sind die meerwasserbeständige Aluminiumlegierung "Hydronalium" (mit 7 Gew.% Magnesium und wenig Silizium) und chromhaltige Aluminiumlegierungen.

Bei der Herstellung der Mehrschichtenpigmente wird in bekannter Weise vorgegangen. In einem Roll-Coater (Vakuumbeschichtungsapparatur mit einem innenliegenden aufund abrollbaren Folienwickel) wird eine Folie, die zuvor mit einer Release-Schicht versehen wurde, über Physical Vapor Deposition sukzessive mit einer semitransparenten Aluminium-Schicht (5-40 nm Dicke), dann einer transparenten SiO₂-Schicht (100-600 nm Dicke), dann einer opaken Aluminiumschicht (> 60 nm Dicke), dann wieder mit einer transparenten SiO₂-Schicht (100-600 nm Dicke) und schließlich mit einer semitransparenten Aluminiumschicht (5-40 nm Dicke) beschichtet. Anstelle von reinem Aluminium können für die zentrale Aluminiumschicht und/oder für die beiden semitransparenten Aluminiumschichten auch aluminiumbasierende Legierungen verwendet werden. Das Verdampfen des Aluminiums oder aluminiumbasierenden Metalls erfolgt elektrisch über widerstandsbeheizte Schiffchen oder durch Sputtering. Für optisch variable Pigmente wird Sputtering vorgezogen. Auch für die Verdampfung von SiO₂- bzw. von SiO₂-haltigen Schichten ist Sputtering die bevorzugte Methode. Das Versetzen von SiO₂ mit Kryolith erweist sich als vorteilhaft, da der Aufbau der SiO₂/Kryolith-Schicht sehr viel rascher erfolgt als der Aufbau einer reinen SiO₂-Schicht und Kryolith etwa die gleiche Brechzahl hat wie SiO₂.

Zur Herstellung des Pigments aus dem mehrschichtigen Film wird zunächst die Release-Schicht mit Hilfe eines Lösemittels aufgelöst, der Film wird vom Substrat abgeschält und die dabei anfallenden Filmbruchstücke werden, gegebenenfalls nach Waschen und Filtrieren, zerkleinert. Die Zerkleinerung der Filmbruchstücke auf Pigmentgröße erfolgt durch Ultraschall oder mechanisch durch Hochgeschwindigkeitsrührer in einem flüssigen Medium oder nach Trocknung derselben in einer Luftstrahlmühle mit Sichterrad. Die freien Metalloberflächen des Pigments, das in einer Teilchengröße zwischen 5 und 60 µm, vorzugsweise zwischen 12 und 36 µm anfällt, werden je nachdem die Pigmentzerkleinerung in flüssigem Medium oder trocken vorgenommen wird, bereits während des Zerkleinerungsvorganges oder im Anschluß daran durch eines der vorstehend genannten erfindungsgemäßen Verfahren mit einer passivierenden Schutzschicht belegt.

Wird die Passivierung während des Zerkleinerungsvorganges vorgenommen, so werden dem flüssigen Medium, in dem die Filmbruchstücke bei der Zerkleinerungsbehandlung vorliegen, z. B. Carbonsäure, Phosphorsäure oder Phosphorsäureester oder Chromsäure zugesetzt. Dabei muß das Medium für das jeweils zugesetzte Passivierungs-Agens zumindest eine gewisse Löseeigenschaft haben. Passivieren des trockenen Pulvers z. B. durch Zumischen von z. B. Metalloxiden, Polymeren, höheren Fettsäuren oder von Phosphorsäureestern in feinteiliger Form ist ebenfalls möglich, ebenso Passivierung in der Gasphase z. B. bei der Zerkleinerung von Filmbruchstücken in einer Luftstrahlmühle, jedoch weniger bevorzugt. Im bevorzugten Fall werden Carbonsäuren, Phosphorsäure, Phosphormolybdänsäure oder Phosphorsäureester, Chromsäure oder auch Gemische mehrerer Passivierungsagenzien in wässerigen, alkoholischen, ketonartigen, alkanartigen, etherartigen oder anderen organischen Lösemitteln wie Tetrahydrofuran, Propylacetat oder Toluol oder auch Gemischen derselben angewendet. Bei den Carbonsäuren sind die höheren Fettsäuren wie Stearinsäure, Ölsäure, Myristinsäure oder etwa Salze, wie z. B. Natriumstearat oder Zinkstearat besonders geeignet. Auch Dicarbonsäuren oder deren Salze können eingesetzt werden.

Phosphorsäure kann als ein- oder mehrbasige Säure zum Einsatz kommen. Unter den möglichen Phosphorsäureestern sind solche auf Basis höherer Fettalkohole besonders bevorzugt. Chromsäure (CrO₃) wird zweckmäßigerweise als 20-%ige wässerige Lösung appliziert.

Die Konzentration des passivierenden Agens im flüssigen Medium wird im Normalfall zwischen 5 und 30 Gew.% gewählt. Im Ausnahmefall flüssiger Passivierungsmittel kann auch im 100-%igen Konzentrat gearbeitet werden, so z. B. bei Ölsäure. Die passivierende Behandlung im flüssigen Medium selbst erfolgt bevorzugt über 1-5 Stunden. Während dieser Zeit wird die pigmenthaltige Suspension schonend gerührt. Nach der Behandlung wird das Pigment abfiltriert, gegebenenfalls gewaschen und getrocknet. Die Notwendigkeit des Waschens besteht nur bei der CrO₃-Behandlung. Eine "Nachreifephase", während der das Pigment 3-4 Wochen ausschließlich lagert, erhöht die Qualität der Passivierung aller Erfahrung nach. Analysen zeigen, daß je nach Partikelgröße 0 - 30 Gew.% des passivierenden Agens fest auf die Oberfläche des Pigments "aufzieht".

Die korrosionsstabilen Ein- und Mehrschichtenpigmente nach der Erfindung werden zur Materialeinfärbung, insbesondere zur Einfärbung dekorativer Beschichtungen im Lack-, Anstrichmittel-, Kunststoff-, Druck- und Keramik-Sektor angewendet.

Zur schnellen Überprüfung der Wirksamkeit der Passivierung, d. h. der Wasserbeständigkeit der Pigmente, dient beispielsweise der in DE-A 40 30 727 beschriebene Kochtest in Wasser. Dabei werden 1,5 g des zu testenden Metall- bzw. Mehrfilmpigments als Paste in 10 g Butylglykol vordispergiert und dann zu 150 g Wasser in eine gasdicht verschließbare Apparatur gegeben. Man erhitzt dann bis zum Sieden und registriert die Zeit, die bis zur Entwicklung von 400 ml Wasserstoff benötigt wird.
Nicht stabilisierte Pigmente reagieren innerhalb weniger Minuten ab. Die erfindungsgemäß hergestellten Pigmente erfordern dagegen Kochzeiten von mindestens 15 h bis 400 ml Wasserstoff entwickelt sind.

Die folgenden Beispiele dienen der weiteren Erläuterung der Erfindung und veranschaulichen anhand des vorstehend genannten Tests die erzielte Passivierung und Korrosionsbeständigkeit der Pigmente nach der Erfindung.

### Beispiele:

### Herstellung von metallhaltigen Partikeln als Ausgangsprodukt für die Pigmentherstellung.

A. In einem Roll Coater wird auf eine mit einer acrylharzbasierenden Release-Schicht beschichtete Polyester-Folie durch Verdampfen von geschmolzenem Aluminium eine 90 nm dicke Aluminiumschicht aufgebracht. Die Schicht wird dem Roll Coater entnommen und mit Hilfe von Aceton durch Anlösen der Release-Schicht abgeschält. Die Bruchstücke der Schicht werden abdekantiert und mit Testbenzin gewaschen (300% Restlösemittel).
B. In einem Roll Coater werden auf eine mit einer acrylharzbasierenden Release-Schicht beschichtete Polyester-Folie übereinander der Reihe nach folgende Schichten durch Sputtering aufgebracht:
   1. (M') eine 10 nm dicke semitransparente Aluminiumschicht
   2. (T) eine 500 nm dicke transparente SiO₂-Schicht
   3. (M) eine 60 nm dicke opake Aluminiumschicht
   4. (T) eine 500 nm dicke transparente SiO₂-Schicht
   5. (M') eine 10 nm dicke semitransparente Aluminiumschicht.

   Man erhält einen Mehrschichtenfilm, der einen deutlichen Grün/Rot-Farbflop aufweist. Dieser Film wird dem Roll-Coater entnommen und mit Lösemittel (THF/Wasser/Ethanol = 1:1:1, oder Aceton) vom Substrat abgeschält. Die Bruchstücke werden abfiltriert.
C. Vorgehen wie unter A. mit dem Unterschied, daß die Schichten 1. (M'), 3. (M) und 5. (M') nicht aus reinem Aluminium, sondern aus einer Aluminium/Chrom-Legierung (95 Gew.% Al, 5 Gew.% Cr) bestehen.
D. Vorgehen wie unter A. mit dem Unterschied, daß die Schichten 1. (M'), 3. (M) und 5. (M') nicht aus reinem Aluminium, sondern aus einer Hydronalium-Legierung (92,9 Gew.% Al, 7 Gew.% Mg, 0,1 Gew.% Si) bestehen.

### Passivierung der Bruchstücke

### Beispiel 1: Beschichtung von Einschichtpigmenten

Der lösemittel- und aluminiumfilmbruchstücke-haltige Slurry gem. Beispiel A. wird in eine Chromsäure (CrO₃)-haltige wässrige Lösung eingetragen, die 12 Gew.% CrO₃ und 88 Gew.% Wasser enthält. Anschließend wird die Suspension im Ultraschallzerkleinerer über 60 Minuten bei 30° C behandelt. Dann wird das Pigment dekantiert, mehrmals mit Isopropanol gewaschen und schließlich in die Endform einer verkaufsfertigen isopropanolhaltigen Paste gebracht.

### Beispiel 2: Beschichtung mit Ölsäurelösung

Die unter B. hergestellten Mehrschichtenfilm-Fragmente werden lösemittelfeucht in eine Ölsäure (C₁₇H₃₃COOH) enthaltende alkoholische Lösung (30 Gew.% Ölsäure, 70 Gew.% Ethanol) eingetragen und anschließend in einem handelsüblichen Ultraschallzerkleinerer über etwa 1 Stunde behandelt. Danach liegt die Partikelgröße zwischen 3 und 60 µm. Anschließend werden die Partikel bei 40° C noch über weitere 4 Stunden schonend gerührt. Danach wird abgekühlt, filtriert, mit einer Lösung bestehend aus 95 Gew.% Ethanol und 5 Gew.% Ölsäure gewaschen und bei 50° C im Vakuumtrockenschrank getrocknet. Anschließend wird das Pulver 4 Wochen bei Raumtemperatur gelagert.

Das so passivierte Pigmentpulver weist einen C-Anteil von 4 Gew.% auf.

### Beispiel 3: Beschichtung mit Phosphatlösung

Die unter B. hergestellten Mehrschichtenfilm-Bruchstücke werden lösemittelfeucht in eine Triethylphosphat ((C₂H₅)₃PO₄) enthaltende alkoholische Lösung (20 Gew.% Triethylphosphat, 77 Gew.% Ethanol, 3 Gew.% H₂O) eingetragen und dann im Ultraschallzerkleinerer über ca. 1 Stunde behandelt. Danach liegt die Partikelgröße zwischen 3 und 60 µm. Anschließend werden die Partikel bei 50° C noch weitere 3 Stunden schonend gerührt. Danach wird abgekühlt und bei 50° C im Vakuumtrockenschrank getrocknet. Das Pulver wird über 4 Wochen bei Raumtemperatur gelagert.

Das dergestalt passivierte Pigmentpulver weist einen P-Anteil von 0,4 Gew.% auf.

### Beispiel 4: Beschichtung mit Chromatlösung

Die unter B. hergestellten Mehrschichtenfilm-Fragmente werden lösemittelfeucht in eine Chromsäure (CrO₃)-haltige wässerige Lösung eingetragen. Die Lösung enthält 10 Gew.% CrO₃ und 90 Gew.% H₂O. Anschließend werden die Fragmente im Ultraschallzerkleinerer über ca. 1 Stunde auf Partikelgrößen zwischen 3 und 60 µm gebracht. Danach wird die Suspension über 2 Stunden bei 40° C schonend gerührt, dann wird das Pigment filtriert und mit Wasser gewaschen. Es wird bei 60° C im Vakuumtrockenschrank getrocknet und 2 Wochen gelagert.

Das Pigment enthält 1,4 Gew.% Chrom.

### Beispiel 5: Beschichtung mit Zinkstearatlösung

Das unter C. hergestellte Mehrschichtenfilm-Material wird im Vakuumtrockenschrank bei 50° C getrocknet und dann in eine Wasser/Xylol-haltige Zinkstearat-Lösung (10 Gew.% Zinkstearat, 5 Gew.% Wasser, 85 Gew.% Xylol) eingetragen und im Ultraschallzerkleinerer auf Partikelgrößen zwischen 5 und 50 µm gebracht. Danach wird unter schonendem Rühren die Suspension 2 Stunden lang auf 80° C erhitzt. Danach wird das Pigment abfiltriert, im Vakuumtrockenschrank bei 50° C getrocknet und 4 Wochen lang gelagert.

### Beispiel 6: Beschichtung mit Chromatlösung

Die unter D. hergestellten Mehrschichtenfilm-Fragmente werden lösemittelfeucht in Chromsäure (CrO₃)-haltige Lösung (15 Gew.% CrO₃, 85 Gew.% H₂O) eingetragen und in einem Ultraschallzerkleinerer auf Partikelgrößen zwischen 5 und 60 µm gebracht. Danach wird die Suspension bei 40° C zwei Stunden lang gerührt. Anschließend wird das Pigment abfiltriert, mit H₂O gewaschen, bei 60° C im Vakuumtrockenschrank bei 50° getrocknet und 4 Wochen gelagert.

### Beispiel 7: Polymerbeschichtung in Lösung

125 g von durch PVD hergestellten einschichtigen Pigmentpartikeln mit einer mittleren Teilchengröße von 18 µm werden in 1300 g Testbenzin dispergiert und auf 120°C erhitzt. Zuerst werden 7,6 g 3-Methacryloxypropyltrimethoxysilan in 20 g Testbenzin und anschließend 0,3 g Vinylphosphonsäure in 20 g Testbenzin, 0,3 g Wasser und 5,0 g 2-Butanol zugegeben und 1 h bei 120°C umgerührt. Danach werden 12 g Trimethylolpropantrimethacrylat in 20 g Testbenzin und anschließend innerhalb von 30 min eine Aufschlämmung von 0,4 g 2,2-Azobis (2-methylpropannitril) in 10 g Testbenzin zugegeben. Man rührt 5 h bei 120°C, läßt die Reaktionsmischung abkühlen und trennt das beschichtete Pigment über eine Filternutsche ab. Der erhaltene Filterkuchen wird im Vakuumtrockenschrank vom Lösemittel befreit.
Im Kochtest entwickelt das Pigment nach 22 h nur 100 ml Wasserstoff.

### Beispiel 8: Polymerbeschichtung in Lösung

Gemäß der Arbeitsweise von Beispiel 7 werden korrosionsstabile Pigmente unter Verwendung von 0,2 g 2-Carboxyethanphosphonsäure bzw.0,2 g Aminoethanphosphonsäure anstelle von 0,3 g Vinylphosphonsäure erzeugt.

Im Kochtest entwickeln die so hergestellten Pigmente nach 20 h 120 ml bzw. 125 ml Wasserstoff.

### Beispiel 9: Beschichtung mit Phosphat nach einem CVD-Verfahren

100 g einschichtige Pigmentteilchen (mittlere Teilchengröße 20 µm) wurden im Wirbelschichtreaktor durch Einleiten von insgesamt 800 l/h Stickstoff als Wirbelgas fluidisiert und auf 200°C erhitzt. 200 l/h der Wirbelgase wurden durch eine auf 70°C erwärmte und mit 20 ml POCl₃ beschickte Vorlage geleitet. Weitere 200 l/h Stickstoff wurden in einer zweiten auf 50°C erwärmten und mit Wasser beschickten Vorlage mit Wasserdampf beladen und in den Reaktor überführt. Der Rest der Wirbelgase wurde direkt durch die untere Öffnung des Reaktors über den Frittenboden eingeblasen.

Nach etwa 2 h war die gesamte POCl₃-Menge verbraucht. Die Analyse ergab 0,82 Gew-% P im passivierten Pigment. Im Kochtest entwickelte das Pigment nach 22 h 90 ml Wasserstoff.

### Beispiel 10: Beschichtung mit Phosphit nach einem CVD-Verfahren

Analoges Vorgehen gemäß Beispiel 9, jedoch unter Verwendung von 24 ml Trimethylphosphit bei einer Vorlagentemperatur von 20°C und 3 h Reaktionszeit.
Das fertige Pigment enthielt 2,8 Gew.% P; im Kochtest entwickelte es nach 24 h 60 ml Wasserstoff.

### Beispiel 11: Beschichtung mit Vanadat nach einem CVD-Verfahren

Analoges Vorgehen gemäß Beispiel 9, jedoch unter Verwendung von 28 ml VOCl₃ bei einer Vorlagentemperatur von 20°C und 5 h Reaktionszeit.
Das so beschichtete Pigment enthielt 13 Gew.% V; im Kochtest bildeten sich in 22 h 360 ml Wasserstoff.

### Beispiel 12: Beschichtung mit Molybdänsäure in Lösung

200 g Pigmentpartikel (mittlere Teilchengröße 15 µm) wurden in 2000 ml Proplyenglykolmonomethylether dispergiert und bei 15-20°C bei einem pH-Wert von 9 mit einer wäßrigen Lösung von 20 g Ammoniumparamolybdat (NH₄)₆Mo₇O₂₄ . 4 H₂O in 400 g demineralisiertem Wasser tropfenweise versetzt. Nach 1 h Reaktionszeit wurde das Reaktionsprodukt mittels Filternutsche isoliert und mehrfach mit demineralisiertem Wasser gewaschen, um Ammoniumsalze und nicht abreagiertes Molybdat zu entfernen. Das auf diese Weise beschichtete Pigment enthielt 5,2 Gew.% Mo und entwickelte im Kochtest nach 24 h 85 ml Wasserstoff.

### Beispiel 13: Beschichtung mit Cersilicatlösung

100 g Pigmentpulver (mittlere Teilchengröße 12 µm) werden in 600 ml Propylenglykolmonobutylether dispergiert und mit einer wäßrigen Lösung von 50 g Cersilikat 15 h bei Raumtemperatur gerührt. Anschließend wurde das Pigment über eine Filternutsche abgetrennt.
Das erhaltene Pigmentpulver enthielt 14,0 Gew.% Ce und bildete im Kochtest nach 22 h 150 ml Wasserstoff.

### Beispiel 14: Beschichtung mit Organophosphiten (RO)₂PHO

100 g Pigmentpulver wurden in 1000 g Testbenzin dispergiert und mit 8 g Dioctylphosphit in 100 g Testbenzin bei Raumtemperatur versetzt und 24 h intensiv gerührt. Anschließend wurde das Pigment mittels Filternutsche abgetrennt und bei 90°C im Vakuumtrockenschrank getrocknet. Das so beschichtete Pigment enthielt 0,76 Gew.% P und entwickelte im Kochtest nach 20 h 90 ml Wasserstoff.

### Beispiel 15: Beschichtung mit modifizierten Titanaten in Lösung

100 g Pigmentpulver wurden in 800 g Ethylacetat homogen dispergiert, mit einer Lösung von 20 g Isopropyltri(dioctyl)pyrophosphatotitanat (KR 38S, Fa. Kenrich) in 100 g Ethylacetat versetzt und 24 h bei Raumtemperatur intensiv gerührt. Anschließend wurde das Pigment vom Lösemittel separiert und im Vakuumtrockenschrank bei 50°C getrocknet.
Das beschichtete Pigment enthielt 0,5 Gew.% Ti und 2,2 Gew.% P und entwickelte im Kochtest nach 24 h 70 ml Wasserstoff.

## Patentansprüche

1. Durch Physical Vapor Deposition (PVD) hergestellte Metallpigmente auf Aluminiumbasis,die durch Zerkleinerung eines durch PVD erzeugten Metallfilms **und während des Zerkleinerungsvorgangs oder im Anschluß daran stattfindende Passivierung** erhalten werden, **wodurch** alle nach der Zerkleinerung freiliegenden Metallflächen, insbesondere die Bruchflächen, der Metallpigment-Partikel mit einer gegen einen Angriff durch wässerige, insbesondere saure oder alkalische, Medien passivierenden Schutzschicht belegt sind.

2. Metallpigmente nach Anspruch 1, die zur Erzielung variabler Farbeffekte einen Mehrschichtenaufbau des Typs M'TMTM' haben, wobei M' eine semitransparente Aluminium- oder aluminiumbasierende Metallschicht, T ein transparentes niedrigbrechendes Dielektrikum und M eine hochreflektierende opake Aluminium- oder aluminiumbasierende Schicht sind und wobei auf die Schicht M' zusätzlich eine passivierende Schutzschicht aufgebracht ist, **dadurch gekennzeichnet, daß** die Schutzschicht sich auch über die Bruchflächen der Pigmentteilchen erstreckt.

3. Metallpigmente nach Anspruch 1 oder 2, **dadurch gekennzeichnet, daß** die passivierende Schutzschicht aus einem Stoff der Gruppe Carbonsäuren, Phosphorsäure, Phosphonsäuren und Derivate dieser Stoffe mit 8 bis 20 C-Atomen oder aus salzartigen Verbindungen der Stoffe der genannten Gruppe besteht.

4. Metallpigmente nach Anspruch 1 oder 2, **dadurch gekennzeichnet, daß** die passivierende Schutzschicht aus mindestens einer Metalloxidschicht und/oder Metalloxidhydratschicht aus Metallen der Gruppe B, Al, Sn, Ti, V, Cr, Mo, Zn, Ce besteht.

5. Metallpigmente nach Anspruch 1 oder 2, **dadurch gekennzeichnet, daß** die passivierende Schutzschicht aus einem organisch modifizierten Silikat, Titanat, Zirkonat oder Aluminiumzirkonat besteht.

6. Metallpigmente nach Anspruch 1 oder 2, **dadurch gekennzeichnet, daß** die passivierende Schutzschicht aus einem organischen Polymer auf Basis von Acrylaten und/oder Methacrylaten besteht.

7. Metallpigmente nach einem der Ansprüche 1 bis 6, **dadurch gekennzeichnet, daß** die Metallschicht bzw. Metallechichten aus einer korrosionsstabilen Aluminiumlegierung besteht bzw. bestehen.

8. Metallpigmente nach Anspruch 7, **dadurch gekennzeichnet, daß** die Aluminiumlegierung eine chromhaltige Aluminiumlegierung ist.

9. Verfahren zur Erzeugung korrosionsstabiler Metallpigmente auf Aluminiumbasis, die im Wege der Physical Vapor Deposition (PVD) und anschließende Zerkleinerung des entstandenen Metallfilms hergestellt sind, **dadurch gekennzeichnet, daß während des Zerkleinerungsvorgangs oder im Anschluß daran** die durch die Zerkleinerung erhaltenen Pigmente mit einem oder mehreren Stoffen der Gruppe Carbonsäure, Phosphonsäuren, Phosphorsäure, Phosphormolybdänsäure, Alkohole, Amine, Amide und Derivate dieser Stoffe behandelt werden.

10. Verfahren nach Anspruch 9, **dadurch gekennzeichnet, daß** die Pigmente mit Derivaten mit 8 bis 20 C-Atomen der genannten Stoffe behandelt werden.

11. Verfahren nach Anspruch 9 oder 10, **dadurch gekennzeichnet, daß** die Pigmente in Lösungen von salzartigen Verbindungen der genannten Stoffe oder deren Derivaten behandelt werden.

12. Verfahren zur Erzeugung korrosionsstabiler Metallpigmente auf Aluminiumbasis, die im Wege der Physical Vapor Deposition (PVD) und anschließenden Zerkleinerung des entstandenen Metallfilms hergestellt sind, **dadurch gekennzeichnet, daß während des Zerkleinerungsvorgangs oder im Anschluß daran** auf die freien Metallflächen der durch die Zerkleinerung erhaltenen Pigmente als passivierende Schutzschicht eine Metalloxidund/oder Metalloxidhydratschicht durch Hydrolyse von Salzen oder Metallsäureestern aus der Gruppe B, Al, Sn, Ti, V, Cr, Mo, Zn, Ce aufgefällt wird.

13. Verfahren zur Erzeugung korrosionsstabiler Metallpigmente auf Aluminiumbasis, die im Wege der Physical Vapor Deposition (PVD) und anschließenden Zerkleinerung des entstandenen Metallfilms hergestellt sind, **dadurch gekennzeichnet, daß während des Zerkleinerungsvorgangs oder im Anschluß daran** auf die freien Metallflächen der durch die Zerkleinerung erhaltenen Pigmente als passivierende Schutzschicht eine organisch modifizierte Silikat-, Titanat-, Zirkonat- oder Aluminiumzirkonatschicht aus entsprechenden organischen Lösungen oder durch Hydrolyse entsprechend modifizierter Metallsäureester aufgebracht wird.

14. Verfahren zur Erzeugung korrosionsstabiler Metallpigmente auf Aluminiumbasis, die im Wege der Physical Vapor Deposition (PVD) und anschließenden Zerkleinerung des entstandenen Metallfilms hergestellt sind, **dadurch gekennzeichnet, daß während des Zerkleinerungsvorgangs oder im Anschluß daran** auf die freien Metallflächen der durch die Zerkleinerung erhaltenen Pigmente als passivierende Schutzschicht eine organische Polymerschicht auf Basis von Acrylaten und/oder Methacrylaten durch radikalische Polymerisation in Lösung aufgebracht wird.

15. Verfahren nach einem der Ansprüche 9 bis 14, **dadurch gekennzeichnet, daß** ein die passivierende Schutzschicht bildender Stoff oder eine Komponente davon die Release-Schicht bei der Herstellung der Aluminiumpigmente im Wege des PVD bildet und daß während des Zerkleinerungsvorgangs oder im Anschluß daran des Metallfilms die Release-Schicht aufgelöst und als Schutzschicht auf die freien Metallflächen der Metallteilchen aufgebracht bzw. durch Zugabe einer entsprechenden Schutzschicht-Komponente mit dieser zur Reaktion gebracht und das Reaktionsprodukt als Schutzschicht aufgebracht wird.

16. Verwendung der Metallpigmente nach einem der Ansprüche 1 bis 8 oder der Metallpigmente, hergestellt nach einem der Verfahren gemäß den Ansprüchen 9 bis 15, in Farben und Lacken, Druckfarben und Kunststoffen.

## Claims

1. Aluminium-based metal pigments produced by physical vapour deposition (PVD) and obtained by comminution of a metal film produced by PVD and passivation taking place during the comminution operation or thereafter, whereby all metal surfaces exposed after comminution, especially the fracture surfaces, of the metal pigment particles are covered with a protective layer providing passivation against attack by aqueous, especially acidic or alkaline, media.

2. Metal pigments according to Claim 1, which to obtain variable colour effects have a multi-layer structure of the type M'TMTM', wherein M' is a semi-transparent aluminium or aluminium-based metal layer, T is a transparent dielectric of low refractive index and M is a highly reflecting opaque aluminium or aluminium-based layer and wherein additionally a passivating protective layer has been applied to the layer M', **characterized in that** the protective layer also extends over the fracture surfaces of the pigment particles.

3. Metal pigments according to Claim 1 or 2, **characterised in that** the passivating protective layer is composed of a substance selected from the group consisting of carboxylic acids, phosphoric acid, phosphonic acid and derivatives of said substances with from 8 to 20 carbon atoms or of salt-like compounds of the substances of said group.

4. Metal pigments according to Claim 1 or 2, **characterized in that** the passivating protective layer is composed of at least one metal oxide layer and/or metal oxide hydrate layer of metals of the group consisting of B, Al, Sn, Ti, V, Cr, Mo, Zn and Ce.

5. Metal pigments according to Claim 1 or 2, **characterized in that** the passivating protective layer is composed of an organically modified silicate, titanate, zirconate or aluminium zirconate.

6. Metal pigments according to Claim 1 or 2, **characterized in that** the passivating protective layer is composed of an organic polymer based on acrylates and/or methacrylates.

7. Metal pigments according to one of Claims 1 to 6, **characterized in that** the metal layer or layers is or are composed of a corrosion-stable aluminium alloy.

8. Metal pigments according to Claim 7, **characterized in that** the aluminium alloy is a chromium-containing aluminium alloy.

9. Process for producing corrosion-stable aluminium-based metal pigments produced by physical vapour deposition (PVD) and subsequent comminution of the resultant metal film, **characterized in that** during the comminution operation or thereafter the pigments obtained by the comminution are treated with one or more substances from the group consisting of carboxylic acid, phosphonic acids, phosphoric acid, phosphomolybdic acid, alcohols, amines, amides and derivatives of said substances.

10. Process according to Claim 9, **characterized in that** the pigments are treated with derivatives having from 8 to 20 carbon atoms of said substances.

11. Process according to Claim 9 or 10, **characterized in that** the pigments are treated in solutions of salt-like compounds of said substances or derivatives thereof.

12. Process for producing corrosion-stable aluminium-based matal pigments produced by physical vapour deposition (PVD) and subsequent comminution of the resultant metal film, **characterized in that** during the comminution operation or thereafter a metal oxide layer and/or metal oxide hydrate layer is precipitated as a passivating protective layer onto the free metal surfaces of the pigments obtained by the comminution, by hydrolysis of salts or metal acid esters from the group consisting of B, Al, Sn, Ti, V, Cr, Mo, Zn and Ce.

13. Process for producing corrosion-stable aluminium-based metal pigments produced by physical vapour deposition (PVD) and subsequent comminution of the resultant metal film, **characterized in that** during the comminution operation or thereafter an organically modified silicate, titanate, zirconate or aluminium zirconate layer is applied as a passivating protective layer to the free metal surfaces of the pigments obtained by the comminution, from corresponding organic solutions or by hydrolysis of correspondingly modified metal acid esters.

14. Process for producing corrosion-stable aluminium-based metal pigments produced by physical vapour deposition (PVD) and subsequent comminution of the resultant metal film, **characterized in that** during the comminution operation or thereafter an organic polymer layer based on acrylates and/or methacrylates is applied as a passivating protective layer to the free metal surfaces of the pigments obtained by the comminution, by free-radical polymerization in solution.

15. Process according to one of Claims 9 to 14, **characterized in that** a substance which forms the passivating protective layer, or a component of said substance, forms the release layer during the production of the aluminium pigments by PVD and **in that** during the comminution operation on the metal film or thereafter the release layer is dissolved and is applied as a protective layer to the free metal surfaces of the metal particles and/or, through the addition of a corresponding protective-layer component, the release layer is reacted therewith and the reaction product is applied as a protective layer.

16. Use of the metal pigments according to one of Claims 1 to 8 or of the metal pigments produced by one of the processes according to Claims 9 to 15 in paints and varnishes, printing inks and plastics.

## Revendications

1. Pigments métalliques à base d'aluminium préparés par dépôt physique en phase vapeur (DPV), qui sont obtenues pas concassage d'un film métallique obtenu par DPV et passivation intervenant au cours du processus de concassage, ou en addition à celui-ci, pigments dans lesquels toutes les surfaces métalliques dégagées après le concassage, en particulier les surfaces de rupture des particules de pigments métalliques sont recouvertes d'une couche protectrice passivante vis-à-vis d'une attaque par agents aqueux, en particulier acides ou alcalins.

2. Pigments métalliques selon la revendication 1, **caractérisés en ce que**, en vue d'atteindre des effets colorés, il est créé une structure multicouches du type M'TMTM', dans lequel M' représente une couche métallique semi-transparente en aluminium à base d'aluminium, T représente un diélectrique transparent à bas coefficient de réfraction et M représente une couche opaque à coefficient de réflexion élevé en aluminium ou à base d'aluminium, par-dessus la couche M' étant déposée une couche de protection passivante additionnelle, ces pigments étant **caractérisés en ce que** la couche protectrice s'étend également sur les surfaces de rupture des particules de pigments.

3. Pigments métalliques selon la revendication 1 ou 2, **caractérisés en ce que** la couche passivante se compose d'une substance choisie dans le groupe constitué par les acides carboxyliques, les acides phosphoriques, les acides phosphoniques et leurs dérivés ayant 8 à 20 atomes de carbone, ou les composés obtenus par salification des substances appartenant au groupe précité.

4. Pigments métalliques selon la revendication 1 ou 2, **caractérisés en ce que** la couche protectrice passivante se compose d'au moins une couche d'oxyde métallique et/ou d'hydrate d'oxyde métallique, de métaux du groupe B, Al, Sn, Ti, V, Cr, Mo, Zn et Ce.

5. Pigments métalliques selon la revendication 1 ou 2, **caractérisés en ce que** la couche protectrice passivante se compose d'un silicate, un titanate, ou un zirconate organiquement modifié, ou d'un zirconate d'aluminium.

6. Pigments métalliques selon la revendication 1 ou 2, **caractérisés en ce que** la couche protectrice passivante se compose d'un polymère organique à base d'acrylates et/ou de méthacrylates.

7. Pigments métalliques selon l'une quelconque des revendications 1 à 6, **caractérisés en ce que** la (ou les) couche(s) métallique(s) se compose(nt) d'un alliage d'aluminium stable vis-à-vis de la corrosion.

8. Pigments métalliques selon la revendication 7, **caractérisés en ce que** l'alliage métallique est un alliage d'aluminium contenant du chrome.

9. Procédé pour l'obtention de pigments métalliques à base d'aluminium stables vis-à-vis de la corrosion, qui sont préparés au cours d'un processus physique de dépôt en phase vapeur (DPV) puis par concassage du film métallique en résultant, **caractérisé en ce que**, au cours des processus de concassage ou en addition à celui-ci, les pigments obtenus par le concassage sont traités par une ou plusieurs substances choisies dans le groupe constitué par les acides carboxyliques, les acides phosphoriques, les acides phosphoniques, les acides phosphomolybdéniques, les alcools, les amines, les amides et les dérivés de ces substances.

10. Procédé selon la revendication 9, **caractérisé en ce que** les pigments sont traités avec des dérivés à 8 à 20 atomes de carbone des substances précitées.

11. Procédé selon la revendication 9 ou 10, **caractérisé en ce que** les pigments sont traités avec des solutions de composés salifiés des substances précitées ou de leurs dérivés.

12. Procédé pour l'obtention de pigments métalliques à base d'aluminium stables vis-à-vis de la corrosion qui sont préparés au cours d'un processus physique de dépôt en phase vapeur (DPV) puis par concassage du film métallique en résultant, **caractérisé en ce que**, au cours du processus de concassage ou en addition à celui-ci, sur les surfaces métalliques libres des pigments obtenus par le concassage, est déposée, en tant que couche protectrice passivante, une couche d'oxyde métallique et/ou une couche d'hydrate d'oxyde métallique, par hydrolyse de sels ou d'esters d'acides métalliques choisis dans le groupe B, Al, Sn, Ti, V, Cr, Mo, Zn et Ce.

13. Procédé pour l'obtention de pigments métalliques à base d'aluminium stables vis-à-vis de la corrosion qui sont préparés au cours d'un processus physique de dépôt en phase vapeur (DPV) puis par concassage du film métallique en résultant, **caractérisé en ce que**, au cours du processus de concassage ou en addition à celui-ci, sur les surfaces métalliques libres des pigments obtenus par le concassage, est appliquée, en tant que couche protectrice passivante, une couche modifiée organiquement de silicate, titanate, zirconate ou de zirconate d'aluminium, à partir de solutions organiques correspondantes ou par hydrolyse d'esters d'acides métalliques modifiés correspondants.

14. Procédé pour l'obtention de pigments métalliques à base d'aluminium stables vis-à-vis de la corrosion qui sont préparés au cours d'un processus physique de dépôt en phase vapeur (DPV) puis par concassage du film métallique en résultant, **caractérisé en ce que**, au 'cours du processus de concassage ou en addition à celui-ci, sur les surfaces métalliques libres des pigments obtenus par le concassage, est appliquée, en tant que couche protectrice passivante, une couche polymère organique à base d'acrylates et/ou de méthacrylates, par polymérisation radicalaire en solution.

15. Procédé selon l'une quelconque des revendications 9 à 14, **caractérisé en ce qu'**une substance formant la couche protectrice passivante ou un composant de celle-ci forme la couche de dégagement (ou "couche de releasing") lors de la fabrication des pigments au cours du DPV, et **en ce que**, au cours du processus de concassage, ou en addition à celui-ci, la couche de dégagement est dissoute du film métallique, et amenée, en tant que couche protectrice, sur les surfaces métalliques libres des particules métalliques, ou bien, par addition d'un composant correspondant de la couche de protection, est amenée à réagir avec elle, et le produit de la réaction est appliqué en tant que couche protectrice.

16. Utilisation des pigments métalliques selon l'une quelconque des revendications 1 à 8 ou des pigments métalliques fabriqués selon l'un des procédés selon les revendications 9 à 15, dans des colorants et des laques, des colorants pour l'impression et les matières artificielles.
